# DEMANDE DE BREVET EUROPEEN

(11) **EP 3 432 694 A1**
(43) Date de publication de la demande: **23.01.2019**
(21) Numéro de dépôt: 18184776.5
(22) Date de dépôt: 20.07.2018
(51) Int. Cl.: H05K 7/14

(54) **PROCEDE DE MONTAGE D'UN MODULE ELECTRIQUE SUR UN SUPPORT ELECTRIQUEMENT CONDUCTEUR ET DISPOSITIFS ELECTRIQUES CORRESPONDANTS**

(30) Priorité: 21.07.2017 FR 1756951
(71) Demandeur: VALEO EQUIPEMENTS ELECTRIQUES MOTEUR, 94046 Créteil Cedex (FR)
(72) Inventeur: ZHANG, Jintao, SHENZHEN, Guangdong 518128 (CN); LUCOT, Guillaume, SHANGHAI, Shanghai 200233 (CN); FALGUIER, Manuel, 94046 CRETEIL (FR)
(74) Mandataire: Cardon, Nicolas

(57) **Abrégé**

Le module électrique (110) comportant des conducteurs électriques (406) électriquement connectés entre eux par au moins un composant électrique, le procédé comporte : la fixation des conducteurs électriques (406) au support (202) en intercalant un matériau isolant électrique entre chaque conducteur électrique (406) et le support (202), et la vérification de l'isolation électrique entre au moins un des conducteurs électriques (406) et le support (202).

Le procédé comporte en outre la fixation d'un conducteur électrique de jonction (408) à la fois sur un premier des conducteurs électriques (406) et le support (202) afin de les connecter électriquement.

## Description

### DOMAINE TECHNIQUE

La présente invention concerne un procédé de montage d'un module électrique sur un support électriquement conducteur et des dispositifs électriques correspondants.

### ARRIÈRE-PLAN TECHNOLOGIQUE

On connait de l'état de la technique un procédé de montage d'un module électrique sur un support électriquement conducteur, le module électrique comportant des conducteurs électriques électriquement connectés entre eux par au moins un composant électrique, le procédé comportant :
- la fixation des conducteurs électriques au support en intercalant un matériau isolant électrique entre chaque conducteur électrique et le support,
- la vérification de l'isolation électrique entre au moins un des conducteurs électriques et le support.

Par exemple, le procédé connu précédent peut être utilisé dans la fabrication d'un convertisseur de tension comportant des modules de puissance montés sur un dissipateur de chaleur. En effet, chaque module de puissance comporte généralement un ou plusieurs bras de hachage réalisés chacun par un conducteur électrique positif, un conducteur électrique de phase (destiné à être connecté à une phase d'une machine électrique), un conducteur électrique de masse, un interrupteur de côté haut électriquement connecté entre le conducteur électrique positif et le conducteur électrique de phase et un interrupteur de côté bas électriquement connecté entre le conducteur électrique de phase et le conducteur électrique de masse. Dans cet exemple, il est connu d'utiliser deux barres omnibus connectées respectivement aux conducteurs électriques positif et de masse pour connecter le module de puissance à une source de tension continue.

L'invention a pour but de proposer un procédé de montage permettant de simplifier la connexion du module électrique.

### RÉSUMÉ DE L'INVENTION

À cet effet, il est proposé un procédé de montage d'un module électrique sur un support électriquement conducteur, le module électrique comportant des conducteurs électriques électriquement connectés entre eux par au moins un composant électrique, le procédé comportant :
- la fixation des conducteurs électriques au support en intercalant un matériau isolant électrique entre chaque conducteur électrique et le support,
- la vérification de l'isolation électrique entre au moins un des conducteurs électriques et le support,
le procédé étant caractérisé en ce qu'il comporte en outre :
- la fixation d'un conducteur électrique de jonction à la fois sur un premier des conducteurs électriques et le support afin de les connecter électriquement.

Grâce à l'invention, il est possible d'utiliser le support électriquement conducteur pour connecter le premier conducteur électrique.

De façon optionnelle, le composant électrique est un composant électronique de puissance, par exemple un transistor de type MOSFET ou de type IGBT.

De façon optionnelle également, le module électrique est un module de puissance.

De façon optionnelle également, le module électrique est un module de puissance d'un convertisseur de tension.

De façon optionnelle également, le support est un dissipateur de chaleur.

En particulier, dans l'exemple du convertisseur de tension, il est possible de n'utiliser qu'une seule barre omnibus pour connecter le module de puissance, puisque le dissipateur de chaleur est utilisé comme masse électrique.

De façon optionnelle également, le premier des conducteurs électriques fixé au conducteur électrique de jonction est un conducteur de masse.

De façon optionnelle également, le procédé comporte en outre :
- le montage du premier conducteur électrique sur un premier pion, de sorte qu'une ouverture du premier conducteur électrique reçoive le premier pion,

De façon optionnelle, le procédé comporte en outre :
- le montage du premier conducteur électrique sur un premier pion, de sorte qu'une ouverture du premier conducteur électrique reçoive le premier pion,
et la fixation du conducteur électrique de jonction comporte :
- le montage du conducteur électrique de jonction sur le premier pion, de sorte qu'une première ouverture du conducteur électrique de jonction reçoive le premier pion et que le conducteur électrique de jonction repose sur le premier conducteur électrique,
- le rivetage du premier pion de manière à maintenir le conducteur électrique de jonction au contact du premier conducteur électrique.

De façon optionnelle également, le support comporte le premier pion.

De façon optionnelle également, le procédé comporte en outre le montage du conducteur électrique de jonction sur un deuxième pion, de sorte qu'une deuxième ouverture du conducteur électrique de jonction reçoive le deuxième pion et que le conducteur électrique de jonction repose sur le support.

De façon optionnelle également, le procédé comporte en outre :
- le montage du conducteur électrique de jonction sur un deuxième pion, de sorte qu'une deuxième ouverture du conducteur électrique de jonction reçoive le deuxième pion et que le conducteur électrique de jonction repose sur le support,
- le rivetage du deuxième pion de manière à maintenir le conducteur électrique de jonction au contact du support.

De façon optionnelle également, le support comporte le deuxième pion.

De façon optionnelle également, le matériau isolant électrique comporte de la colle.

De façon optionnelle également, le premier conducteur électrique est un conducteur électrique de masse, dans lequel les conducteurs électriques comportent en outre un conducteur électrique positif et un conducteur électrique de phase destiné à être connecté à une phase d'une machine électrique, et dans lequel les composants électriques comportent un interrupteur de côté haut connecté entre le conducteur électrique positif et le conducteur électrique de phase et un interrupteur de côté bas connecté entre le conducteur électrique de phase et le conducteur électrique de masse.

De façon optionnelle également, le support est un dissipateur de chaleur destiné à dissiper la chaleur du ou des composants électriques.

Il est également proposé un dispositif électrique, par exemple un convertisseur de tension, obtenu par un procédé de fabrication comportant un procédé selon l'invention de montage d'un module électrique sur un support électriquement conducteur.

Il est également proposé un dispositif électrique, par exemple un convertisseur de tension, comportant :
- un module électrique comportant des conducteurs électriques électriquement connectés entre eux par au moins un composant électrique,
- un support électriquement conducteur auquel les conducteurs électriques sont fixés,
- un matériau isolant électrique intercalé entre chaque conducteur électrique et le support,
caractérisé en ce qu'il comporte en outre :
- un conducteur électrique de jonction fixé à la fois sur un premier des conducteurs électriques et le support.

De façon optionnelle, le composant électrique est un composant électronique de puissance, par exemple un transistor de type MOSFET ou de type IGBT.

De façon optionnelle également, le dispositif électrique est un onduleur ou un pont redresseur ou encore un chargeur de batterie à bord (en anglais « On Board Charger » ou OBC) d'un véhicule automobile.

De façon optionnelle également, le module électrique est un module de puissance.

De façon optionnelle également, le module électrique est un module de puissance d'un convertisseur de tension.

De façon optionnelle également, le support est un dissipateur de chaleur.

De façon optionnelle également, le support comprend au moins un premier pion.

De façon optionnelle également, le support comprend au moins un deuxième pion.

De façon optionnelle également, le conducteur électrique de jonction comprend une première ouverture.

De façon optionnelle également, le conducteur électrique de jonction comprend une deuxième ouverture.

De façon optionnelle également, ledit au moins un premier pion du support est positionnés dans ladite première ouverture du conducteur électrique de jonction.

De façon optionnelle également, ledit au moins un deuxième pion du support est positionnés dans ladite deuxième ouverture du conducteur électrique de jonction.

De façon optionnelle également, le support présente en outre une embase au pied dudit au moins un deuxième pion.

De façon optionnelle également, le conducteur électrique de jonction est au contact à la fois du premier des conducteurs électrique fixé au conducteur électrique de jonction et de l'embase au pied dudit au moins un deuxième pion du support.

De façon optionnelle également, le premier des conducteurs électriques fixé au conducteur électrique de jonction est percé d'une ouverture de réception du premier pion du support.

De façon optionnelle également, le premier conducteur électrique est monté sur le premier pion du support de sorte que l'ouverture de réception du premier conducteur électrique reçoive le premier pion du support.

De façon optionnelle également, le conducteur électrique de jonction est monté sur le premier pion du support de sorte que la première ouverture du conducteur électrique de jonction reçoive le premier pion du support.

De façon optionnelle également, le premier pion est riveté de manière à maintenir le conducteur électrique de jonction au contact du premier conducteur électrique.

De façon optionnelle également, le premier des conducteurs électriques fixé au conducteur électrique de jonction est un conducteur de masse.

De façon optionnelle également, le premier des conducteurs électriques fixé au conducteur électrique de jonction présente une partie externe dépassant horizontalement du boitier du module électrique et reposant sur une languette horizontale dudit boitier.

De façon optionnelle également la languette horizontale est percée d'une ouverture de réception du premier pion du support.

De façon optionnelle également, le conducteur électrique de jonction est monté sur le deuxième pion de sorte que la deuxième ouverture du conducteur électrique de jonction reçoive le deuxième pion et que le conducteur électrique de jonction repose sur le support.

### DESCRIPTION DES FIGURES

La figure 1 est un schéma électrique d'un système électrique mettant en oeuvre l'invention.
La figure 2 est une vue en trois dimensions d'un convertisseur de tension du système électrique de la figure 1.
La figure 3 est une vue en trois dimensions d'un dissipateur de chaleur du convertisseur de tension de la figure 2.
La figure 4 est une vue en trois dimensions du convertisseur de tension de la figure 2, avec des barres omnibus et des boîtiers retirés.
La figure 5 est une vue en coupe d'un mécanisme de connexion électrique entre un conducteur de masse et le dissipateur de chaleur, avant une opération de rivetage.
La figure 6 est une vue en coupe du mécanisme de connexion électrique de la figure 5, après l'opération de rivetage.
La figure 7 est un schéma-blocs illustrant les étapes d'un procédé selon l'invention de montage d'un module électrique sur un support électriquement conducteur.
La figure 8 est une vue en trois dimensions d'un mécanisme alternatif de connexion électrique entre le conducteur de masse et le dissipateur de chaleur, avant une opération de rivetage.

### DESCRIPTION DÉTAILLÉE

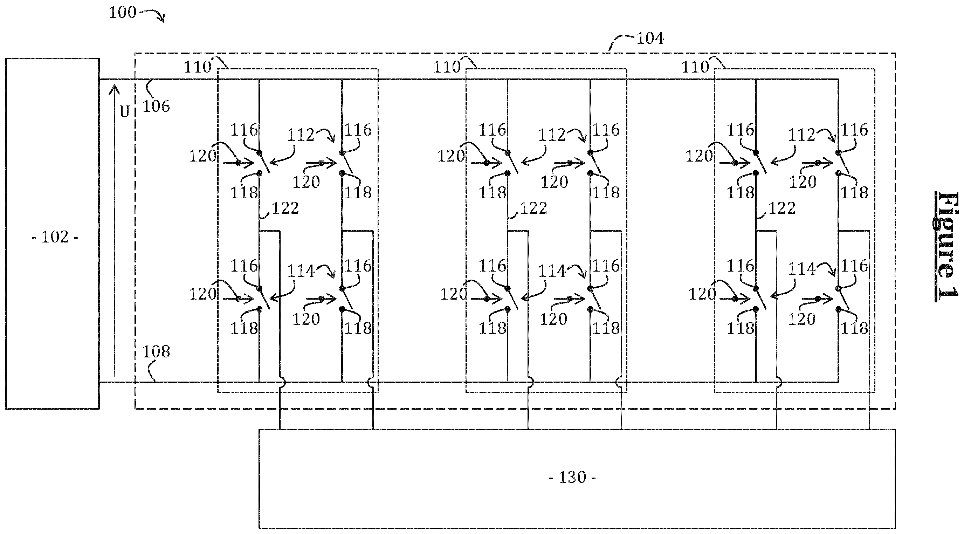

En référence à la figure 1, un système électrique 100 mettant en oeuvre l'invention va à présent être décrit.

Le système électrique 100 est par exemple destiné à être implanté dans un véhicule automobile.

Le système électrique 100 comporte tout d'abord une source d'alimentation électrique 102 conçue pour délivrer une tension continue U, par exemple comprise entre 10 V et 100 V, par exemple 12 V. La source d'alimentation électrique 102 comporte par exemple une batterie.

Le système électrique 100 comporte en outre une machine électrique 130 comportant plusieurs phases (non représentées) destinées à présenter des tensions de phase respectives.

Le système électrique 100 comporte en outre un convertisseur de tension 104 connecté entre la source d'alimentation électrique 102 et la machine électrique 130 pour effectuer une conversion entre la tension continue U et les tensions de phase.

Le convertisseur de tension 104 comporte une barre omnibus positive 106 et une masse électrique 108 destinés à être connectés à la source d'alimentation électrique 102 pour recevoir la tension continue U, la barre omnibus positive 106 recevant un potentiel électrique haut et la masse électrique 108 recevant un potentiel électrique bas.

Le convertisseur de tension 104 comporte en outre au moins un module de puissance 110 comportant une ou plusieurs barres omnibus de phase 122 destinées être respectivement connectées à une ou plusieurs phases de la machine électrique 130, pour fournir leurs tensions de phase respectives.

Dans l'exemple décrit, le convertisseur de tension 104 comporte trois modules de puissance 110 comportant chacun deux barres omnibus de phase 122 connectées à deux phases de la machine électrique 130.

Plus précisément, dans l'exemple décrit, la machine électrique 130 comporte deux systèmes triphasés comportant chacun trois phases, et destinés à être électriquement déphasés de 120° l'un par rapport à l'autre. De préférence, les premières barres omnibus de phase 122 des modules de puissance 110 sont respectivement connectées aux trois phases du premier système triphasé, tandis que les deuxièmes barres omnibus de phase 122 des modules de puissance 110 sont respectivement connectées aux trois phases du deuxième système triphasé.

Chaque module de puissance 110 comporte, pour chaque barre omnibus de phase 122, un interrupteur de côté haut 112 connecté entre la barre omnibus positive 106 et la barre omnibus de phase 122 et un interrupteur de côté bas 114 connecté entre la barre omnibus de phase 122 et la masse électrique 108. Ainsi, les interrupteurs 112, 114 sont agencés de manière à former un bras de hachage, dans lequel la barre omnibus de phase 122 forme un point milieu.

Chaque interrupteur 112, 114 comporte des première et deuxième bornes principales 116, 118 et une borne de commande 120 destinée à sélectivement ouvrir et fermer l'interrupteur 112, 114 entre ses deux bornes principales 116, 118 en fonction d'un signal de commande qui lui est appliqué. Les interrupteurs 112, 114 sont de préférence des transistors, par exemple des transistors à effet de champ à structure métal-oxyde-semiconducteur (de l'anglais « Métal Oxide Semiconductor Field Effect Transistor » ou MOSFET) présentant une grille formant la borne de commande 120, et un drain et une source formant respectivement les bornes principales 116, 118.

Dans l'exemple décrit, les interrupteurs 112, 114 ont chacun la forme d'une plaque, par exemple sensiblement rectangulaire, présentant une face supérieure et une face inférieure. La première borne principale 116 s'étend sur la face inférieure, tandis que la deuxième borne principale 118 s'étend sur la face supérieure. En outre, la face inférieure forme une face de dissipation de chaleur.

Il sera apprécié que la barre omnibus positive 106, la masse électrique 108 et les barres omnibus de phase 122 sont des éléments rigides conçus pour supporter des courants électriques d'au moins 1 A. Par exemple, les barres omnibus 106, 122 sont en forme de plaque présentant de préférence une épaisseur d'au moins 1 mm.

En outre, dans l'exemple décrit, la machine électrique 130 est un alterno-démarreur. Plus précisément, le véhicule automobile comporte en outre un moteur thermique (non représenté) présentant un axe de sortie auquel la machine électrique 130 est reliée par une courroie (non représentée). Le moteur thermique est destiné à entraîner des roues du véhicule automobile par l'intermédiaire de son axe de sortie. Ainsi, en fonctionnement comme alternateur, la machine électrique fournit de l'énergie électrique en direction de la source d'alimentation électrique 102 à partir de la rotation de l'axe de sortie. Le convertisseur de tension 104 fonctionne alors comme redresseur. En fonctionnement comme démarreur, la machine électrique entraîne l'arbre de sortie du moteur thermique pour son démarrage ou redémarrage. Le convertisseur de tension 104 fonctionne alors comme onduleur.

Dans l'exemple décrit, la machine électrique 130 est localisée en lieu et place de l'alternateur.

Dans la suite de la description, la structure et la disposition d'éléments du convertisseur de tension 104 vont être décrits plus en détail, en référence à une direction verticale H-B, « H » représentant le haut et « B » représentant le bas.

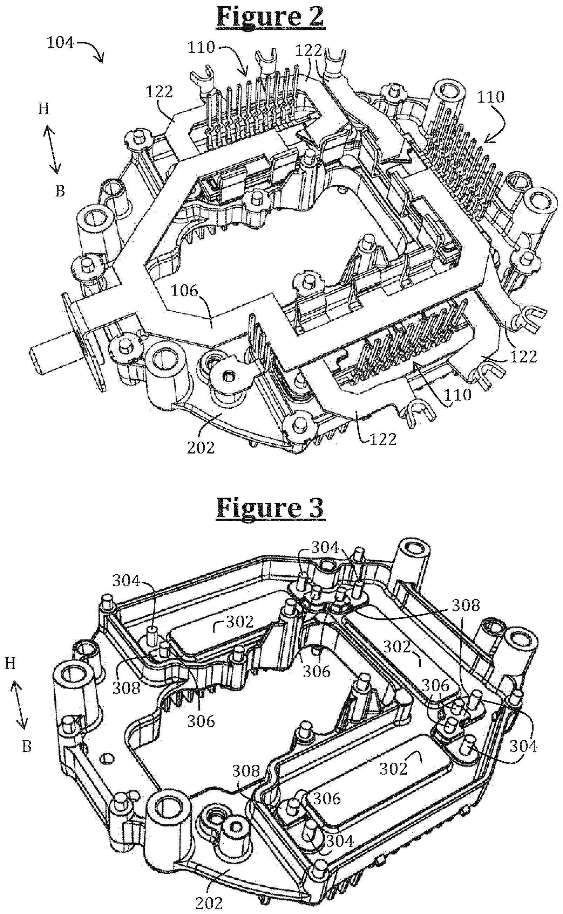

En référence à la figure 2, le convertisseur de tension 104 comporte un dissipateur de chaleur 202 destiné à dissiper la chaleur des interrupteurs 112, 114 et à former une partie de la masse électrique 108.

En référence à la figure 3, le dissipateur de chaleur 202 présente, pour chaque module de puissance 110, un plateau 302 de réception de ce module de puissance 110 ainsi que deux paires de premier et deuxième pions 304, 306. Le dissipateur de chaleur 202 présente en outre une embase 308 au pied de chaque deuxième pion 306. Les plateaux 302, les embases 308 et les pions 304, 306 s'élèvent d'un corps principal du dissipateur de chaleur 202. Dans l'exemple décrit, les plateaux 302, les embases 308 et les pions 304, 306 sont formés d'une seule pièce avec ce corps principal.

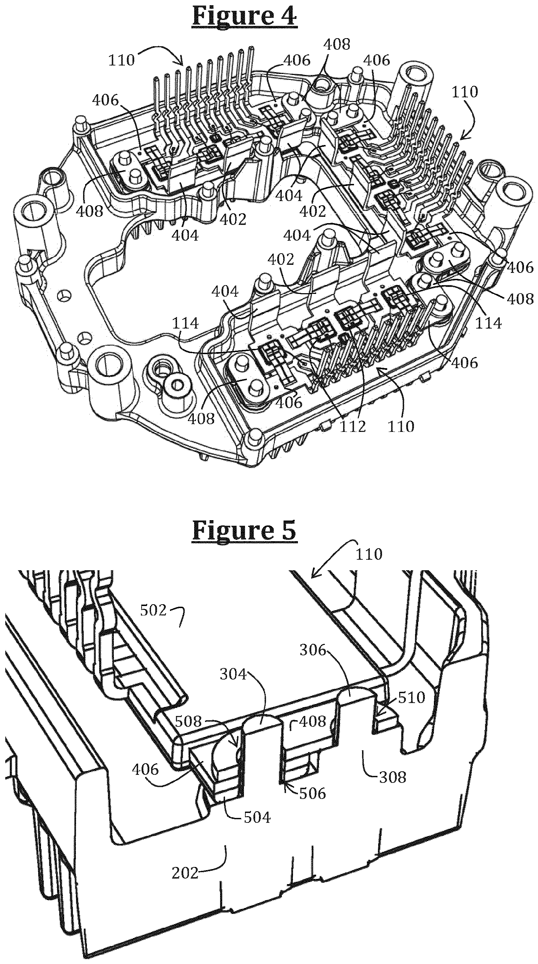

En référence à la figure 4, chaque module de puissance 110 comporte un conducteur électrique positif 402 faisant partie de la barre omnibus positive 106, deux conducteurs électriques de phase 404 faisant respectivement partie des barres omnibus de phase 122 de ce module de puissance 110 et deux conducteurs électriques de masse 406 faisant partie de la masse électrique 108.

Dans l'exemple décrit, les conducteurs électriques 402, 404, 406 sont rigides, en forme de plaque présentant chacune une épaisseur d'au moins 1 mm, et comportent des portions horizontales respectives coplanaires s'étendant horizontalement les unes à côté des autres. Ainsi, un empilement vertical de ces conducteurs électriques 402, 404, 406 est évité, ce qui permet de réduire l'encombrement vertical du module de puissance 110.

Les portions horizontales des conducteurs électriques 402, 404, 406 présentent des faces inférieures respectives plaquées sur le plateau 302 par l'intermédiaire d'un matériau isolant électrique. Dans l'exemple décrit, le matériau isolant électrique comporte de la colle collant les portions horizontales des conducteurs électriques 402, 404, 406 au plateau 302.

Dans l'exemple décrit, chaque interrupteur de côté haut 112 est fixé par sa face inférieure à une face supérieure de la portion horizontale de l'un parmi le conducteur électrique positif 402 et le conducteur électrique de phase 404. Cette fixation permet de connecter électriquement sa première borne principale 116 et en outre d'évacuer la chaleur vers le dissipateur de chaleur 202 au travers de ce conducteur électrique. La deuxième borne principale 118 de l'interrupteur de côté haut 112 est alors connectée électriquement à la portion horizontale de l'autre conducteur électrique par des rubans conducteurs électriques. De même, chaque interrupteurs de côté bas 114 est fixé par sa face inférieure à la portion horizontale de l'un parmi le conducteur électrique de phase 404 et le conducteur électrique de masse 406. Cette fixation permet de connecter électriquement sa première borne principale 116 et en outre d'évacuer la chaleur vers le dissipateur de chaleur 202 au travers de ce conducteur électrique. La deuxième borne principale 118 de l'interrupteur de côté bas 114 est connectée à la portion horizontale de l'autre conducteur électrique par des rubans conducteurs électriques.

Le convertisseur de tension 104 comporte en outre, pour chaque conducteur électrique de masse 406, un conducteur électrique de jonction 408 destiné à connecter électriquement le conducteur électrique de masse 406 au dissipateur de chaleur 202.

En référence à la figure 5, le module de puissance 110 comporte en outre un boîtier 502 isolant électrique qui entoure les conducteurs électriques 402, 404, 406 et les interrupteurs 112, 114 sauf sur un côté inférieur afin de laisser apparent les faces inférieures des portions horizontales des conducteurs électriques 402, 404, 406. Ainsi, ces portions horizontales peuvent être rapportées sur le plateau 302.

En outre, chaque conducteur électrique de masse 406 présente une partie externe dépassant horizontalement du boîtier 502 et reposant sur une languette 504 horizontale respective du boîtier 502. La partie externe du conducteur de masse 406 et la languette 504 associée sont percées d'une ouverture 506 de réception du premier pion 304 du dissipateur de chaleur 202.

Le conducteur électrique de jonction 408 présente deux ouvertures 508, 510 dans lesquelles les pions 304, 306 du dissipateur de chaleur 202 sont respectivement introduits, de sorte que le conducteur électrique de jonction 408 soit au contact à la fois de la partie externe du conducteur électrique de masse 406 et de l'embase 308 du dissipateur de chaleur 202.

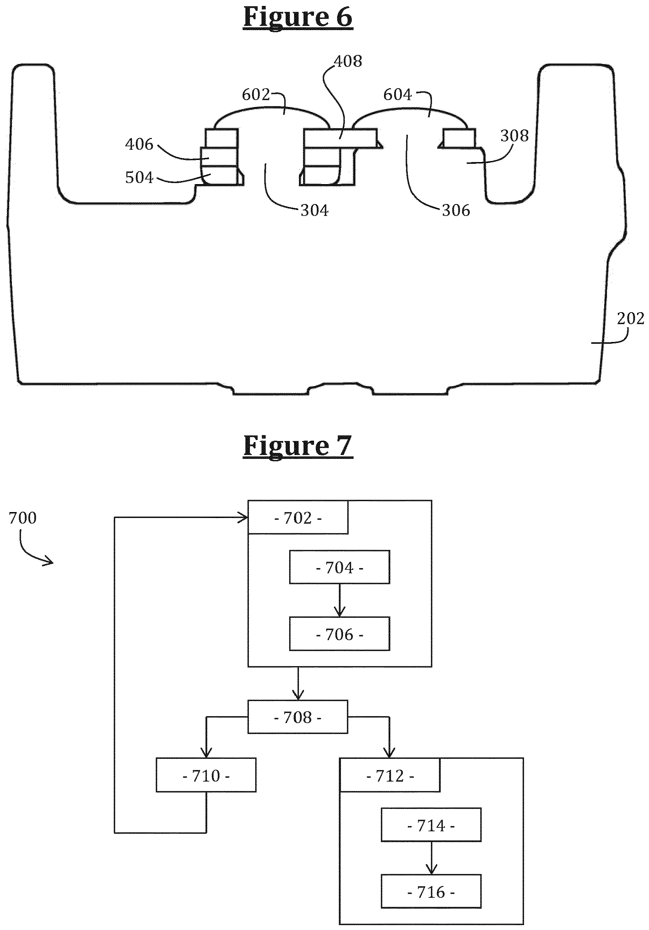

En référence à la figure 6, les pions 304, 306 du dissipateur de chaleur 202 sont destinés à être rivetés. Ainsi, la languette 504 du boîtier 502, la partie externe du conducteur électrique de masse 406 et le conducteur électrique de jonction 408 sont enserrés entre le dissipateur de chaleur 202 et une tête rivetée 602 du premier pion 304. D'autre part, le conducteur électrique de jonction 408 est enserré entre l'embase 308 et une tête rivetée 604 du deuxième pion 306. De cette manière, le conducteur électrique de jonction 408 établit une connexion électrique entre le conducteur électrique de masse 406 et le dissipateur de chaleur 202 au travers d'une surface importante permettant le passage d'un courant important.

En référence à la figure 7, un procédé 700 de montage d'un des modules de puissance 110 sur le dissipateur de chaleur 202 va à présent être décrit. Ce procédé 700 peut être répété pour chacun des modules de puissance 110.

Au cours d'une étape 702, le module de puissance 110 est fixé au dissipateur de chaleur 202 en intercalant un matériau isolant électrique entre chaque conducteur électrique 402, 404, 406 et le dissipateur de chaleur 202.

Pour cela, dans l'exemple décrit, au cours d'une étape 704, de la colle électriquement isolante est appliquée sur le plateau 302 du dissipateur de chaleur 202 où le module de puissance 110 est destiné à être fixé. La colle est par ailleurs conductrice thermique afin de transmettre la chaleur provenant des interrupteurs 112, 114 au dissipateur de chaleur 202. Par exemple, elle présente une conductivité thermique d'au moins 3,5 W.m⁻¹.K⁻¹.

Ensuite, au cours d'une étape 706, le module de puissance 110 est approché du dissipateur de chaleur 202 de manière, d'une part, à poser la face inférieure des portions horizontales des conducteurs électriques 402, 404, 406 sur la colle et, d'autre part, à monter la partie externe du conducteur électrique de masse 406 sur le premier pion 304, de sorte que l'ouverture 506 reçoive le premier pion 304. L'ouverture 506 est dimensionnée de sorte qu'il existe un espace entre le premier pion 304 et la partie externe du conducteur électrique de masse 406 préservant l'isolation électrique entre eux. En outre, la présence de la languette 504 du boîtier 502 évite que la partie externe du conducteur électrique de masse 406 ne vienne contacter le dissipateur de chaleur 202.

Au cours d'une étape 708, l'isolation électrique entre au moins un des conducteurs électriques 402, 404, 406 et le dissipateur de chaleur 202 est vérifiée. Par exemple, une tension (par exemple entre 300 V et 700 V alternatifs, par exemple 500 V alternatifs) est appliquée entre le conducteur électrique 402, 404, 406 testé et le dissipateur de chaleur 202 et le courant résultant de l'application de cette tension est mesuré. Si le courant mesuré est inférieur à un seuil prédéterminé (par exemple compris entre 0,5 mA et 1,5 mA, par exemple 1 mA), par exemple s'il est nul, l'isolation électrique est considérée comme opérationnelle. Dans le cas contraire, l'isolation électrique est considérée comme défectueuse. Cela peut par exemple être le cas, quand la colle a été mal étalée sur le plateau 302. En pratique, tous les conducteurs électriques 402, 404, 406 sont testés en même temps, en les connectant électriquement entre eux de manière provisoire pour le test.

Si l'isolation électrique est défectueuse, au cours d'une étape 710, le module de puissance 110 est retiré pour permettre de refaire l'isolation électrique, puis on retourne à l'étape 702.

Si l'isolation électrique est opérationnelle, au cours d'une étape 712, le conducteur électrique de jonction 408 est fixé à la fois sur le conducteur électrique de masse 406 et le dissipateur de chaleur 202 afin de les connecter électriquement.

Pour cela, dans l'exemple décrit, au cours d'une étape 714, le conducteur électrique de jonction 408 est monté sur les pions 304, 306, de sorte que ses ouvertures 508, 510 reçoivent respectivement les pions 304, 306 et qu'il repose à la fois sur la partie externe du conducteur électrique de masse 406 et sur l'embase 308 du dissipateur de chaleur 202. L'embase 308 permet de compenser l'épaisseur de la languette 504 et de la partie externe du conducteur électrique de masse 406. Ainsi, le conducteur électrique de jonction 408 s'étend sensiblement horizontalement, ce qui facilite le rivetage des pions 304, 306 qui sera réalisé par la suite.

Ensuite, au cours d'une étape 716, les pions 304, 306 sont rivetés de manière à maintenir le conducteur électrique de jonction 408 au contact de respectivement la partie externe du conducteur électrique de masse 406 et l'embase 308 du dissipateur de chaleur 202.

L'opération de rivetage a également pour effet de faire gonfler les pions 304, 306 dans respectivement, d'une part, les ouvertures 506, 508 et, d'autre part, l'ouverture 510. Ainsi, le conducteur électrique de masse 406 et le conducteur électrique de jonction 408 sont bien maintenus mécaniquement.

Le procédé 700 est répété pour chacun des modules de puissance 110.

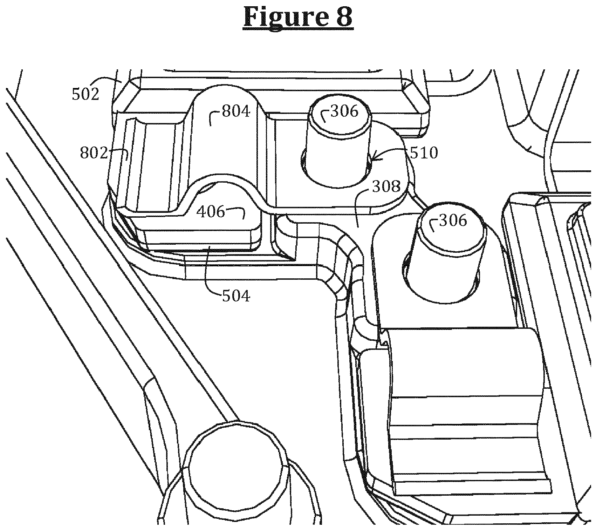

En référence à la figure 8, dans un autre mode de réalisation, le dissipateur de chaleur 202 est dépourvu du pion 304 et le conducteur électrique de jonction, désigné à présent par la référence 802, présente une partie en contact avec la partie externe du conducteur électrique de masse. Le conducteur électrique de jonction 802 est conçu pour être déformé élastiquement lorsque le pion 306 est riveté de manière à ce que sa partie en contact fasse pression contre la partie externe du conducteur électrique de masse 406. Cette pression est suffisante pour établir une connexion électrique fiable entre la partie externe du conducteur électrique de masse 406 et le conducteur électrique de jonction 802. De préférence, pour augmenter la pression, le conducteur électrique de jonction 802 présente une région de forte concavité 804, par exemple présentant un rayon de courbure inférieur à 2 cm, de préférence inférieur à 1 cm.

La présente invention n'est pas limitée aux modes de réalisation décrits précédemment, mais est au contraire définie par les revendications qui suivent. Il sera en effet apparent à l'homme du métier que des modifications peuvent y être apportées.

Par ailleurs, les termes utilisés dans les revendications ne doivent pas être compris comme limités aux éléments des modes de réalisation décrits précédemment, mais doivent au contraire être compris comme couvrant tous les éléments équivalents que l'homme du métier peut déduire à partir de ses connaissances générales.

## Revendications

1. Procédé (700) de montage d'un module de puissance (110) sur un dissipateur de chaleur (202) électriquement conducteur, le module de puissance (110) comportant des conducteurs électriques (402, 404, 406) électriquement connectés entre eux par au moins un composant électrique (112, 114), le procédé comportant :
- la fixation (702) des conducteurs électriques (402, 404, 406) au dissipateur de chaleur (202) en intercalant un matériau isolant électrique entre chaque conducteur électrique (402, 404, 406) et le dissipateur de chaleur (202),
- la vérification (708) de l'isolation électrique entre au moins un des conducteurs électriques (402, 404, 406) et le dissipateur de chaleur (202),
le procédé (700) étant **caractérisé en ce qu'**il comporte en outre :
- la fixation (712) d'un conducteur électrique de jonction (408) à la fois sur un premier des conducteurs électriques (406) et le dissipateur de chaleur (202) afin de les connecter électriquement.

2. Procédé (700) selon la revendication 1, comportant en outre :
- le montage (706) du premier conducteur électrique (406) sur un premier pion (304), de sorte qu'une ouverture (506) du premier conducteur électrique (406) reçoive le premier pion (304),
et dans lequel la fixation du conducteur électrique de jonction (408) comporte :
- le montage (714) du conducteur électrique de jonction (408) sur le premier pion (304), de sorte qu'une première ouverture (508) du conducteur électrique de jonction (408) reçoive le premier pion (304) et que le conducteur électrique de jonction (408) repose sur le premier conducteur électrique (406),
- le rivetage (716) du premier pion (304) de manière à maintenir le conducteur électrique de jonction (408) au contact du premier conducteur électrique (406).

3. Procédé (700) selon la revendication 2, dans lequel le dissipateur de chaleur (202) comporte le premier pion (304).

4. Procédé (700) selon l'une quelconque des revendications 1 à 3, comportant en outre :
- le montage (714) du conducteur électrique de jonction (408) sur un deuxième pion (306), de sorte qu'une deuxième ouverture (510) du conducteur électrique de jonction (408) reçoive le deuxième pion (306) et que le conducteur électrique de jonction (408) repose sur le dissipateur de chaleur (202),
- le rivetage (716) du deuxième pion (306) de manière à maintenir le conducteur électrique de jonction (408) au contact du dissipateur de chaleur (202).

5. Procédé (700) selon la revendication 4, dans lequel le dissipateur de chaleur (202) comporte le deuxième pion (306).

6. Procédé (700) selon l'une quelconque des revendications 1 à 5, dans lequel le matériau isolant électrique comporte de la colle.

7. Procédé (700) selon l'une quelconque des revendications 1 à 6, dans lequel le premier conducteur électrique (406) est un conducteur électrique de masse, dans lequel les conducteurs électriques (402, 404, 406) comportent en outre un conducteur électrique positif (402) et un conducteur électrique de phase (404) destiné à être connecté à une phase d'une machine électrique (130), et dans lequel les composants électriques (112, 114) comportent un interrupteur de côté haut (112) connecté entre le conducteur électrique positif (402) et le conducteur électrique de phase (404) et un interrupteur de côté bas (114) connecté entre le conducteur électrique de phase (404) et le conducteur électrique de masse (406).

8. Procédé (700) selon l'une quelconque des revendications 1 à 7, dans lequel le dissipateur de chaleur (202) est un dissipateur de chaleur destiné à dissiper la chaleur du ou des composants électriques (112, 114).

9. Dispositif électrique (104), par exemple un convertisseur de tension, comportant :
- un module de puissance (110) comportant des conducteurs électriques (402, 404, 406) électriquement connectés entre eux par au moins un composant électrique (112, 114),
- un dissipateur de chaleur (202) électriquement conducteur auquel les conducteurs électriques (402, 404, 406) sont fixés,
- un matériau isolant électrique intercalé entre chaque conducteur électrique (402, 404, 406) et le dissipateur de chaleur (202),
**caractérisé en ce qu'**il comporte en outre :
- un conducteur électrique de jonction (408) fixé à la fois sur un premier des conducteurs électriques (406) et le dissipateur de chaleur (202) pour les connecter électriquement.
